# EUROPEAN PATENT APPLICATION

(11) **EP 4 664 123 A1**
(43) Date of publication of application: **17.12.2025**
(21) Application number: 24182213.9
(22) Date of filing: 14.06.2024
(51) Int. Cl.: G01R 31/26, G01R 31/28, G01R 31/30, H03K 3/03, G01R 31/3185

(54) **METHOD AND ELECTRONIC DEVICE TO DETERMINE THE REMAINING EFFECTIVE LIFETIME OF THE ELECTRONIC DEVICE**

(71) Applicant: Siemens Aktiengesellschaft, 80333 München (DE)
(72) Inventor: Fischer, Bernhard, 2122 Wolkersdorf im Weinviertel (AT); Matschnig, Martin, 3430 Tulln (AT); Cech, Christian, 2483 Ebreichsdorf (AT); Chilku, Bekim, 1190 Wien (AT); Hinterstoisser, Thomas, 2102 Bisamberg (AT); Keskin, Talha, 1110 Wien (AT)
(74) Representative: Siemens Patent Attorneys

(57) **Abstract**

Method to determine the remaining effective lifetime of an electronic device (DEV), which is configured to execute a hardware microservice (HW-MS), the device (DEV) comprising a ring oscillator (RO), an on-chip timer (T), at least one voltage sensor (VS), at least one temperature sensor (TS), a diagnostic memory (EDD DB), a device health reference memory (DHRR), a delay measurement module (DMU), a device health diagnostic module (DHDU), at least one interface (IC, HPSF-IF, LAN) to connect the on-chip timer (T), the diagnostic memory (EDD DB), the reference memory (DHRR), the at least one voltage sensor (VS), the at least one temperature sensor (TS) and the ring oscillator (RO) with the delay measurement unit (DMU) and/or the device health diagnostic unit (DHDU), wherein the hardware microservice is configured to execute following steps:
a) capture a voltage (VOLT),
b) receiving reference values regarding the device voltage (VOLT), the temperature (TEMP), the timing (TIME) from the reference memory (DHRR),
c) receiving threshold values regarding the device voltage (VOLT), the temperature (TEMP), the timing (TIME) from the diagnostic memory (EDD DB),
d) determining the remaining effective lifetime of the electronic device (DEV) by comparing the timing delay (TIME) with the received reference values and the received threshold values,
e) receiving threshold values regarding the device voltage (VOLT), the temperature (TEMP), the timing (TIME) from the diagnostic memory (EDD DB), wherein the threshold values are predefined and stored within the diagnostic memory (EDD DB),
f) determining the remaining effective lifetime of an electronic device (DEV) by comparing the received reference values and the received threshold values.

## Description

The invention relates to a method and an electronic device to determine the remaining effective lifetime of the electronic device.

The term "health" used within this invention is used to refer to the remaining lifetime and ageing of the electronic device and its wear-out (derating) over time.

FPGAs (Field-Programmable Gate Array), in particular realized as a System-on-Chip (SoC), are part of many electronic products, ranging from consumer electronic over factory automation and safety-critical appliances.

The effective lifetime of the FPGA SoC depends on various factors and effects such as device aging, average temperature, maximum voltage, and the clock frequency.

FPGA vendors usually give lifetime guarantees for their devices for different operating conditions.

However, there can be situations, which are problematic when the assumed lifetime is reached earlier than anticipated, which might lead to higher maintenance cycles, product recalls, or the early replacement of faulty components - all having economic, and in some cases, safety-critical impact resulting in human harm.

Statistical estimates for the lifetime of an FPGA can be far off the real lifetime, for example, devices operated with heavy load age earlier due to higher temperatures, or unexpected environment conditions (high temperature, humidity, etc.) might have severe ageing effects on the device, which is represented by the term "health" of the device.

Moreover, a simple miscalculation for product design might also be a reason for an inaccurate lifetime prediction.

Nowadays, approaches for measuring a device's health are usually implemented with hardwired logic on the device measuring voltage and reading temperature sensors, which use up additional chip area and might be not sufficient to predict device ageing.

It is the subject of the invention to improve the measurement of the device's health in an efficient and accurate way.

The objective of the invention is solved by a method to determine the remaining effective lifetime of an electronic device, which is configured to execute a hardware microservice, the device comprising
- a ring oscillator,
- an on-chip timer,
- a diagnostic memory configured to store diagnostic data regarding device ageing information,
- a device health reference memory configured to store threshold values for the device timings,
- a delay measurement module configured to control the ring oscillator and to measure the delay of the ring oscillator using the on-chip timer,
- a device health diagnostic module configured to determine the remaining effective lifetime of an electronic device using the timing in respect to reference data stored in the reference memory,
- at least one interface configured to connect the on-chip timer, the diagnostic memory, the reference memory, and the ring oscillator with the delay measurement unit and/or the device health diagnostic unit,
wherein the hardware microservice is configured to execute following steps:
I. capture a timing delay of the device with the on-chip timer and using the ring oscillator, representing a first physical property in relation to the remaining effective lifetime of the device,
II. receiving reference values regarding the device timing from the reference memory, wherein the reference values are predefined and stored within the reference memory,
III. receiving threshold values regarding the device timing from the diagnostic memory, wherein the threshold values are predefined and stored within the diagnostic memory,
IV. determining the remaining effective lifetime of the electronic device by comparing the timing delay with the received reference values and the received threshold values.

This invention relates to a device health monitoring with a hardware microservice based approach that uses logic elements of an FPGA temporary, since logic elements are free of use after monitoring device health, and a complementary approach including device parameters as timing, device temperature and voltage for measuring the devices health.

Hardware microservices are known as logic that is executed in a dedicated area, the so called "container" or "application container" of an FPGA SoC with dynamic reconfiguration capability.

The device operation is not interrupted when the hardware microservice is downloaded, e.g. via bitstream, to the device.

When the microservice is not needed anymore, the resources occupied can be freed and can become available again for other or new microservices.

The invention applies hardware microservices for a device health diagnostic application, which only needs FPGA SoC resources while in use, like partial dynamic reconfiguration.

Moreover, the ageing of the device is measured with ring oscillators delay time against reference values.

Furthermore, a combined device age analysis is performed with ring oscillator delay time, device temperature, and device voltage supply of the device.

Thus, by analyzing voltage, temperature, and timing delay, and comparing to respective reference values, the health of the electronic device can be determined in a simple and accurate way.

In addition, by performing the health or remaining effective lifetime determination of the electronic device as a hardware microservice within a reconfigurable area of the electronic device, the determination can be executed without consuming device hardware resources permanently, which enables an efficient implementation with respect to the resources of the device.

In a further development of the invention, the diagnostic memory is a database.

Thus, an efficient way to access respective stored data is provided with a simple implementation.

In computing, a database is an organized collection of data, or a type of data store based on the use of a database management system, the software that interacts with end users, applications, and the database itself to capture and analyze the data.

The database management system additionally encompasses the core facilities provided to administer the database.

The database, the database management system and the associated applications can be referred to as a database system.

Small databases can be stored on a file system, while large databases are hosted on computer clusters or cloud storage.

The design of databases spans formal techniques and practical considerations, including data modeling, efficient data representation and storage, query languages, security and privacy of sensitive data, and distributed computing issues, including supporting concurrent access and fault tolerance.

In a further development of the invention, the device health reference memory is a memory table.

Thus, an efficient way to access respective stored data is provided with a simple implementation.

In a further development of the invention, the ring oscillator comprises logic elements, preferably logic gates.

This allows an easy implementation on an FPGA chip.

In a further development of the invention, the ring oscillator comprises a control port to start and stop its oscillation.

This enables a simple means to measure timings, i.e., time periods or time delays.

In a further development of the invention, the delay measurement module uses a predefined number of cycles of the ring oscillator to measure the timing.

Thus, a precise measurement of timings is provided.

In a further development of the invention, the device further comprises at least one sensor further configured to measure a respective second physical property in relation to the remaining effective lifetime of the device, and
- the device health reference memory is further configured to store threshold values for the respective physical property, and
- the device health diagnostic module is further configured to determine the remaining effective lifetime of an electronic device using the respective physical property in respect to reference data stored in the reference memory, and
- the at least one interface is further configured to connect the at least one voltage sensor and/or the at least one temperature sensor with the delay measurement unit and/or the device health diagnostic unit, and
- the hardware microservice is further configured to receive reference values regarding the further physical property from the reference memory, wherein the reference values are predefined and stored within the reference memory,
- the hardware microservice is further configured to receive threshold values regarding the further physical property from the diagnostic memory, wherein the threshold values are predefined and stored within the diagnostic memory,
- determining the remaining effective lifetime of the electronic device by further comparing the captured respective second physical property with the received respective reference values and the received respective threshold values.

Thus, further physical property in relation to the remaining effective lifetime of the device as actual device parameters can be used to increase the accuracy of the determination of the remaining effective lifetime of the device.

The respective second physical property captured is captured by appropriate sensing means and stored as a respective sensor value, which is considered at the determination at step IV)

In a further development of the invention, the at least one sensor is a voltage sensor configured to measure a voltage of the device, and/or the at least one sensor is a temperature sensor configured to measure a temperature of the device, and/or the at least one sensor is a light sensor configured to measure a light illumination of the device, preferably in ultraviolet frequency spectrum.

Thus, the further physical property can be captured in a simple and effective way using simple sensors integrated within the device.

In a further development of the invention, in step IV), if the determination of the remaining effective lifetime of the device returns that the timing delay does not comply with the received reference values and the received threshold values, the hardware microservice is configured to notify the system by an alarm signal, and optionally, the hardware microservice is further configured to send diagnostic measurements to the diagnostic memory.

Thus, the system can recognize the status of the remaining effective lifetime of the device quickly and can initiate adequate measures to mitigate this system limitation.

In a further development of the invention, the hardware microservice is implemented as an application container within a dynamic reconfiguration portion of the device in form of a field programming gate array.

The application container for the method to determine the health or remaining effective lifetime of an electronic device includes the hardware configuration of the FPGA for executing the respective application.

The FPGA comprises a portion e.g. of logic gates, which is reconfigurable during runtime of the FPGA.

In a further development of the invention, the application container is loaded temporarily into the dynamic reconfiguration portion of the device based on a predefined time schedule or a predefined system status of the device.

Thus, the hardware resources of a FPGA can be used in a very efficient way and temporary flexible.

The application container for the method to determine the health or remaining effective lifetime of the device can be loaded temporarily into the FPGA, i.e. the respective device portion is programmed during runtime of the FPGA.

After executing the application container, the respective portion can be released for other application containers.

The mechanism for initiating the temporary loading, execution and release of the application container for the method to determine the health or remaining effective lifetime of the device can be triggered for instance based on a predefined time schedule, like once a day, or a predefined system status of the device, like a memory or processing load profile, which can be determined by the device.

The dynamic reconfiguration portion - or dynamic reconfigurable portion - of the device is the part of configurable (e.g. logic) elements, which can be, after an initial configuration of the device, reconfigured during runtime of the device, i.e. when the FPGA supports at least one reconfigurable hardware microservice.

In a further development of the invention, the hardware microservice is released from the dynamic reconfiguration portion of the field programming gate array for another usage.

Thus, by freeing the part of the reconfigurable portion of the FPGA, used by said application container, the hardware resources of a FPGA can be used in a very efficient way and temporary flexible.

The objective of the invention is also solved by an electronic device to determine the remaining effective lifetime of the electronic device, which is configured to execute a hardware microservice, the device comprising
- a ring oscillator,
- an on-chip timer,
- a diagnostic memory configured to store diagnostic data regarding device ageing information,
- a device health reference memory configured to store threshold values for the device timings,
- a delay measurement module configured to control the ring oscillator and to measure the delay of the ring oscillator using the on-chip timer,
- a device health diagnostic module configured to determine the remaining effective lifetime of the electronic device using the device timing in respect to reference data stored in the reference memory,
- at least one interface configured to connect the on-chip timer, the diagnostic memory, the reference memory and the ring oscillator with the delay measurement unit and/or the device health diagnostic unit,
wherein the hardware microservice is configured to execute the steps of the method according to the invention.

In a further development of the invention, the device further comprises at least one sensor configured to measure a further physical property in relation to the remaining effective lifetime of the device.

In a further development of the invention, the at least one sensor is a voltage sensor configured to measure a voltage of the device, and/or the at least one sensor is a temperature sensor configured to measure a temperature of the device, and/or the at least one sensor is a light sensor configured to measure a light illumination of the device, preferably in ultraviolet frequency spectrum.

An embodiment of the invention is described in detail in the following figures, which show in
- Fig. 1: a schematic embodiment of the invention,
- Fig. 2: an example of a ring oscillator,
- Fig. 3: a flowchart of an embodiment of the method according to the invention.

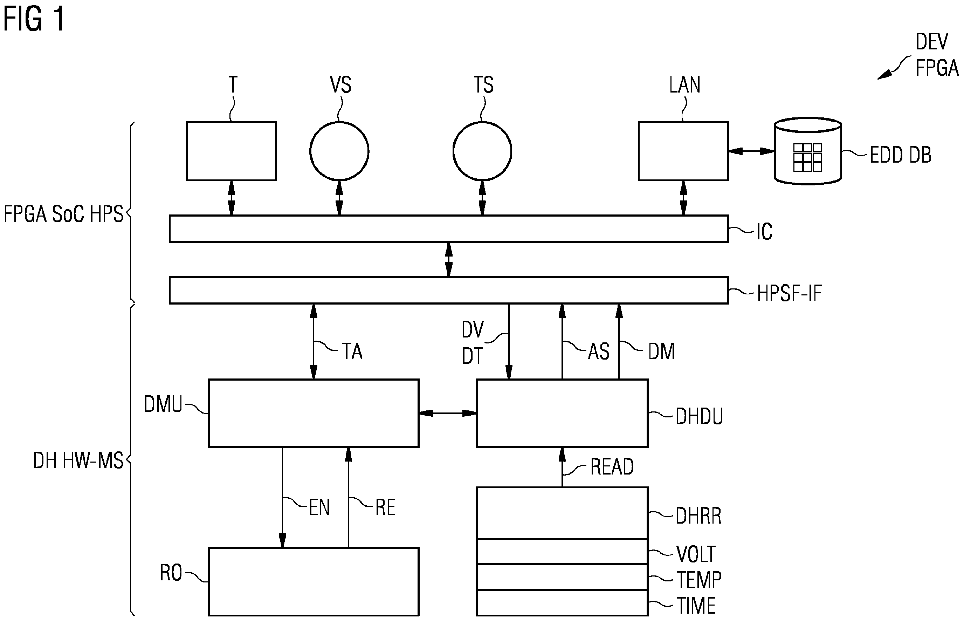

**Fig. 1** shows a schematic embodiment of the invention in form of an electronic device DEV to determine the remaining effective lifetime of the electronic device DEV.

The data flow is also shown in the figure.

The electronic device DEV as a field programming gate array FPGA, which has a hardware microservices HW-MS implemented as a container within a dynamic reconfiguration portion of the field programming gate array FPGA.

Thus, the device's health or remaining effective lifetime is monitored with a device health hardware microservice HW-MS.

The hardware microservice HW-MS is released from the dynamic reconfiguration portion of the FPGA after the determination of the health or remaining effective lifetime of the FPGA for another usage.

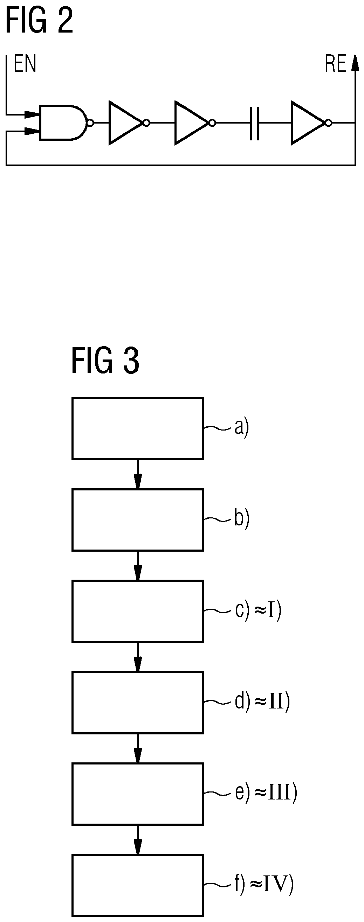

The device DEV comprises a ring oscillator RO, as shown in Fig. 2 as an example, which is configured to generate time pulses as a response signal at an output or response port with a response signal RE with a predefined frequency at a response port, when an enable signal is provided to the ring oscillator RO at a control port EN.

The device DEV comprises further an on-chip timer T, which is configured to count time pulses generated by the timer T.

The device DEV comprises also at least one voltage sensor VS configured to measure a voltage VOLT of the device DEV, i.e. FPGA,

The device DEV comprises also at least one temperature sensor TS configured to measure a temperature TEMP of the device DEV, i.e. FPGA.

Moreover, the FPGA comprises a diagnostic memory EDD DB configured to store diagnostic data regarding device ageing information, wherein the diagnostic memory EDD DB is a database.

The FPGA comprises further a device health reference memory or register DHRR configured to store threshold values for the device voltage VOLT, the device temperature TEMP, and the device timings TIME.

The FPGA includes further a delay measurement module or unit DMU configured to control the ring oscillator RO and to measure the delay of the ring oscillator RO using the on-chip timer T.

In other words, the delay measurement unit DMU controls the ring oscillator RO and accesses the on-chip timer to measure the delay of the ring oscillator RO.

The delay measurement unit DMU applies the on-chip timer to measure the time it takes the ring oscillator RO to run a pre-defined number of cycles, e.g., by utilizing a counter and measured delays are stored.

The FPGA includes further a device health diagnostic module or unit DHDU configured to determine the health or remaining effective lifetime of an electronic device using the device voltage VOLT, the temperature TEMP, the timing TIME in respect to reference data stored in the reference memory DHRR.

The device health diagnostic unit DHDU controls and reads ring oscillator RO delays from the delay measurement unit DMU, and delays are compared against expected delays, requested and received from the reference memory or DHRR, resulting in delta values.

The device health diagnostic unit DHDU also reads data in an operation READ and compares device voltage, temperature, timings to reference data, raises alarm signals and forwards diagnostic data into the diagnostic memory EDD DB, which is for example an external database.

The expected delay obtained from reference data is downloaded as part of the hardware microservice HW-MS and based on statistical information for the FPGA SoC device series.

Delta values give information about device aging - the longer it takes the ring oscillator RO to finish, the more device ageing effects already affected the device.

If the delta values exceed a pre-defined threshold, e.g., the chip is likely to malfunction soon, a signal may be raised to inform on-chip peripherals, e.g., to initiate a safe shutdown procedure.

Other thresholds may be used to initiated device replacement within a certain time frame.

In other words, the delay measurement module DMU uses a predefined number of cycles of the ring oscillator RO to measure the timing TIME.

Furthermore, delta value measured using the ring oscillator RO can, if available, be combined with voltage and temperature data to deduced ageing and remaining device lifetime.

The device healthcare hardware microservice HW-MS can read temperature and voltage values from sensors already located the FPGA SoC device.

Device diagnostic data can be sent back over the network interface LAN into the diagnostic database EDD DB, e.g., located in a cloud environment.

This database ideally holds diagnostic data with ageing information and reference data of all, i.e. other devices in field and acts as data source for maintenance activities, e.g., replacement of the electronic control device.

The FPGA comprises further interfaces like an interconnect interface IC to connect sensors with a Hard-Processing-System HPS fabric interface HPSF-IF or a network connection LAN.

The interfaces IC, HPSF-IF are configured to connect the on-chip timer T, the diagnostic memory EDD DB, the reference memory DHRR, the at least one voltage sensor VS, the at least one temperature sensor TS and the ring oscillator RO with the delay measurement unit DMU and/or the device health diagnostic unit DHDU.

The interfaces IC, HPSF-IF provide timer information TA to the delay measurement unit DMU.

The interfaces IC, HPSF-IF also provide information regarding a device temperature DT and a device voltage DV from the device health diagnostic unit DHDU to respective system entities.

Moreover, the interfaces distribute an alarm signal AS and/or diagnostic measurements DM from the device health diagnostic unit DHDU to respective system entities.

In other words, the interface IC to the FGPA SoC Hard-Processing-System HPS utilizes on-chip timers, registers, and access to voltage and temperature sensors.

The hardware microservice HW-MS running on the FPGA is configured to execute the following steps:
a) capture a voltage VOLT of the device DEV with the at least one voltage sensor VS,
b) capture a temperature TEMP of the device DEV with the at least one temperature sensor TS,
c) capture a timing delay TIME of the device DEV with the on-chip timer T and using the ring oscillator RO,
d) receiving reference values regarding the device voltage VOLT, the temperature TEMP, the timing TIME from the reference memory DHRR, wherein the reference values are predefined and stored within the reference memory DHRR,
e) receiving threshold values regarding the device voltage VOLT, the temperature TEMP, the timing TIME from the diagnostic memory EDD DB, wherein the threshold values are predefined and stored within the diagnostic memory EDD DB,
f) determining the remaining effective lifetime of an electronic device DEV by comparing the received reference values and the received threshold values.

In this example the device further comprises two further sensors, one voltage sensor VS and one temperature sensor TS, configured to measure a respective physical property, i.e. voltage VOLT and temperature TEMP of the device, each in relation to the remaining effective lifetime of the device DEV.

Step c) of this example corresponds to step I) according to the method of the invention, step d) to step II), step e) to step III) and step f) to step IV).

**Fig. 2** depicts an example of a ring oscillator.

The ring oscillator RO comprises logic elements, preferably digital logic gates, and the control port with a control signal EN uses a respective control signal to start and stop its oscillation.

**Fig. 3** shows a flowchart of an embodiment of the method according to the invention. ≈

*Independent of the grammatical term usage, individuals with male, female or other gender identities are included within the term.*

### List of Reference Numerals

- AS: alarm signal
- DEV: electronic device
- DH HW-MS: device health hardware microservice
- DHDU: device health diagnostic unit, device health diagnostic module
- DHRR: device health reference register
- DM: diagnostic measurements
- DMU: device measurement unit, device measurement module
- DT: device temperature
- DV: device voltage
- EDD DB: external device diagnostic database
- EN: enable port, enable signal, control signal
- FPGA: Field Programmable Gate Array
- HPS: Hard-Processing-System
- HPSF-IF: HPS fabric interface
- IC: interconnect
- LAN: Ethernet, local area network
- RE: response port, response signal
- READ: read data
- RO: ring oscillator
- SoC: System on Chip
- T: timer
- TA: timer access
- TEMP: temperature
- TIME: timing, delay
- TS: temperature sensor
- VOLT: voltage
- VS: voltage sensor

## Claims

1. Method to determine the remaining effective lifetime of an electronic device (DEV), which is configured to execute a hardware microservice (HW-MS), the device (DEV) comprising
- a ring oscillator (RO),
- an on-chip timer (T),
- a diagnostic memory (EDD DB) configured to store diagnostic data regarding device ageing information,
- a device health reference memory (DHRR) configured to store threshold values for the device timings (TIME),
- a delay measurement module (DMU) configured to control the ring oscillator (RO) and to measure the delay of the ring oscillator (RO) using the on-chip timer (T),
- a device health diagnostic module (DHDU) configured to determine the remaining effective lifetime of an electronic device using the timing (TIME) in respect to reference data stored in the reference memory (DHRR),
- at least one interface (IC, HPSF-IF, LAN) configured to connect the on-chip timer (T), the diagnostic memory (EDD DB), the reference memory (DHRR), and the ring oscillator (RO) with the delay measurement unit (DMU) and/or the device health diagnostic unit (DHDU),
wherein the hardware microservice (HW-MS) is configured to execute following steps:
I. capture a timing delay (TIME) of the device (DEV) with the on-chip timer (T) and using the ring oscillator (RO), representing a first physical property in relation to the remaining effective lifetime of the device,
II. receiving reference values regarding the device timing (TIME) from the reference memory (DHRR), wherein the reference values are predefined and stored within the reference memory (DHRR),
III. receiving threshold values regarding the device the timing (TIME) from the diagnostic memory (EDD DB), wherein the threshold values are predefined and stored within the diagnostic memory (EDD DB),
IV. determining the remaining effective lifetime of the electronic device (DEV) by comparing the timing delay (TIME) with the received reference values and the received threshold values.

2. Method according to the preceding claim, wherein the diagnostic memory (EDD DB) is a database.

3. Method according to one of the preceding claims, wherein the device health reference memory (DHRR) is a memory table.

4. Method according to one of the preceding claims, wherein the ring oscillator (RO) comprises logic elements, preferably logic gates.

5. Method according to one of the preceding claims, wherein the ring oscillator (RO) comprises a control port (EN) to start and stop its oscillation.

6. Method according to one of the preceding claims, wherein the device further comprises at least one sensor (VS, TS) further configured to measure a respective second physical property (VOLT, TEMP) in relation to the remaining effective lifetime of the device (DEV), and
- the device health reference memory (DHRR) is further configured to store threshold values for the respective physical property, and
- the device health diagnostic module (DHDU) is further configured to determine the remaining effective lifetime of an electronic device using the respective physical property in respect to reference data stored in the reference memory (DHRR), and
- the at least one interface (IC, HPSF-IF, LAN) is further configured to connect the at least one voltage sensor (VS) and/or the at least one temperature sensor (TS) with the delay measurement unit (DMU) and/or the device health diagnostic unit (DHDU), and
- the hardware microservice (HW-MS) is further configured to receive reference values regarding the further physical property (VOLT, TEMP) from the reference memory (DHRR), wherein the reference values are predefined and stored within the reference memory (DHRR),
- the hardware microservice (HW-MS) is further configured to receive threshold values regarding the further physical property (VOLT, TEMP) from the diagnostic memory (EDD DB), wherein the threshold values are predefined and stored within the diagnostic memory (EDD DB),
- determining the remaining effective lifetime of the electronic device (DEV) by further comparing the captured respective second physical property with the received respective reference values and the received respective threshold values.

7. Method according to claim 6, wherein
- the at least one sensor (VS, TS) is a voltage sensor (VS) configured to measure a voltage (VOLT) of the device, and/or
- the at least one sensor (VS, TS) is a temperature sensor (TS) configured to measure a temperature (TEMP) of the device, and/or
- the at least one sensor (VS, TS) is a light sensor configured to measure a light illumination of the device, preferably in ultraviolet frequency spectrum.

8. Method according to one of the preceding claims, wherein the delay measurement module (DMU) uses a predefined number of cycles of the ring oscillator (RO) to measure the timing (TIME).

9. Method according to one of the preceding claims, wherein in step IV), if the determination of the remaining effective lifetime of the device returns that the timing delay (TIME) does not comply with the received reference values and the received threshold values, the hardware microservice (HW-MS) is configured to notify the system by an alarm signal (AS), and optionally, the hardware microservice (HW-MS) is further configured to send diagnostic measurements (DM) to the diagnostic memory (EDD DB).

10. Method according to one of the preceding claims, wherein the hardware microservice (HW-MS) is implemented as an application container within a dynamic reconfiguration portion of the device (DEV) in form of a field programming gate array (FPGA).

11. Method according to the preceding claim, wherein the application container is loaded temporarily into the dynamic reconfiguration portion of the device (DEV) based on a predefined time schedule or a predefined system status of the device (DEV).

12. Method according to the preceding claim, wherein the hardware microservice (HW-MS) is released from the dynamic reconfiguration portion of the field programming gate array (FPGA) for another usage.

13. Electronic device (DEV) to determine the remaining effective lifetime of the electronic device (DEV), which is configured to execute a hardware microservice (HW-MS), the device (DEV) comprising
- a ring oscillator (RO),
- an on-chip timer (T),
- a diagnostic memory (EDD DB) configured to store diagnostic data regarding device ageing information,
- a device health reference memory (DHRR) configured to store threshold values for the device timings (TIME),
- a delay measurement module (DMU) configured to control the ring oscillator (RO) and to measure the delay of the ring oscillator (RO) using the on-chip timer (T),
- a device health diagnostic module (DHDU) configured to determine the remaining effective lifetime of the electronic device (DEV) using the device timing (TIME) in respect to reference data stored in the reference memory (DHRR),
- at least one interface (IC, HPSF-IF, LAN) configured to connect the on-chip timer (T), the diagnostic memory (EDD DB), the reference memory (DHRR) and the ring oscillator (RO) with the delay measurement unit (DMU) and/or the device health diagnostic unit (DHDU),
wherein the hardware microservice is configured to execute the steps of the method according to one of the preceding claims.

14. Electronic device (DEV) according to the preceding claim, wherein the device further comprises at least one sensor (VS, TS) further configured to measure a respective second physical property (VOLT, TEMP) in relation to the remaining effective lifetime of the device (DEV).

15. Electronic device (DEV) according to the preceding claim, wherein
- the at least one sensor (VS, TS) is a voltage sensor (VS) configured to measure a voltage (VOLT) of the device, and/or
- the at least one sensor (VS, TS) is a temperature sensor (TS) configured to measure a temperature (TEMP) of the device, and/or
- the at least one sensor (VS, TS) is a light sensor configured to measure a light illumination of the device, preferably in ultraviolet frequency spectrum.
